# EUROPEAN PATENT APPLICATION

(11) **EP 4 600 956 A1**
(43) Date of publication of application: **13.08.2025**
(21) Application number: 24861344.0
(22) Date of filing: 29.10.2024
(51) Int. Cl.: G11C 5/06

(54) **MEMORY**

(30) Priority: 29.12.2023 CN 202311872679; 19.08.2024 CN 202411141107
(71) Applicant: CXMT Corporation, Hefei, Anhui 230601 (CN)
(72) Inventor: LEE, Hi Choon, Hefei, Anhui 230601 (CN); LI, Xiandong, Hefei, Anhui 230601 (CN)
(74) Representative: Gulde & Partner
(86) International application number: PCT/CN2024/128046
(87) International publication number: WO 2025/139323

(57) **Abstract**

This application provides a memory. The memory includes a memory array chip and a logic circuit chip that are bonded. Each memory array tile corresponds to at least one row decoder, one sub-decoder, and at least one sub-wordline driver. Each row decoder provides a first quantity of main decoding signal lines. The sub-decoder provides a second quantity of sub-decoding signal lines. A product of a total quantity of main decoding signals from all row decoders corresponding to a single memory array tile and the second quantity is the same as a quantity of word lines of the single memory array tile. Each of the at least one sub-wordline driver is configured to drive a word line of the corresponding memory array tile based on the main decoding signal and the sub-decoding signal. A total quantity of drive ports of all sub-wordline drivers corresponding to the single memory array tile is the same as the quantity of word lines of the memory array tile. All of each of the at least one row decoder, the sub-decoder, and each of the at least one sub-wordline driver are disposed in the logic circuit chip. According to the apparatus in this application, a delay between each of the at least one row decoder and each of the at least one sub-wordline driver can be reduced, timing and a sensing margin of the memory can be optimized, and difficulty in routing each of the main decoding signal lines can be lowered.

## Description

This application claims priorities to Chinese Patent Application No. 202311872679.9, filed with the China National Intellectual Property Administration on December 29, 2023 and entitled "MEMORY", and to Chinese Patent Application No. 202411141107.8, filed with the China National Intellectual Property Administration on August 19, 2024 and entitled "MEMORY", which are incorporated herein by reference in their entireties.

### TECHNICAL FIELD

This application relates to semiconductor technologies, and in particular, to a memory.

### BACKGROUND

A semiconductor memory device includes multiple memory array tiles (MATs), and each memory array tile includes memory cells arranged in an array. During reading of information from a memory, a memory cell address code corresponding to the to-be-read information needs to be obtained, and then a corresponding memory cell row code is read based on the memory cell address code, and a corresponding word line (WL) is activated based on the memory cell row code. After the word line is activated, a memory cell connected to the word line is in a readable/writable state. Correspondingly, a row decoder (Row Decoder or X-Decoder, X-DEC for short), a sub-decoder (FX), and a sub-wordline driver are disposed in the memory. The row decoder is configured to: generate a main decoding signal based on a first part of the memory cell address code, and transmit the main decoding signal to the sub-wordline driver through a main decoding signal line (Main Word Line). The sub-decoder is configured to: generate a sub-decoding signal based on a second part of the memory cell address code, and transmit the sub-decoding signal to the sub-wordline driver through a sub-decoding signal line. The sub-wordline driver is connected to the row decoder, the sub-decoder, and the word line, and is configured to drive the corresponding word line based on the main decoding signal and the sub-decoding signal.

In actual application, because the main decoding signal line needs to be connected to sub-wordline drivers corresponding to all memory array tiles, the main decoding signal line needs to traverse an entire section, resulting in an excessively long routing length. Consequently, delays for the main decoding signal output by the row decoder to arrive at the memory array tiles are different, resulting in relatively poor timing uniformity and degrading performance of the memory. In addition, there are a relatively large quantity of main decoding signals, and for each main decoding signal, one main decoding signal line is required to transmit the main decoding signal from the row decoder to the sub-wordline driver. As the area of the semiconductor memory device decreases and a planar process is utilized for most memories, a width and a spacing of the main decoding signal line are limited, increasing difficulty in routing the main decoding signal line.

### SUMMARY

This application provides a memory, to reduce a delay between a row decoder and a sub-wordline driver, optimize timing and a sensing margin of the memory, and lower difficulty in routing a main decoding signal line.

According to an aspect, this application provides a memory. The memory includes a memory array chip and a logic circuit chip that are bonded. The logic circuit chip is located above the memory array chip. Multiple sections arranged in an array are disposed in the memory array chip, and each section includes multiple memory array tiles.

Each memory array tile corresponds to at least one row decoder, each row decoder provides a first quantity of main decoding signal lines, and each of the main decoding signal lines is configured to transmit a main decoding signal. Each section corresponds to one sub-decoder, the sub-decoder provides a second quantity of sub-decoding signal lines, and each of the sub-decoding signal lines is configured to transmit a sub-decoding signal. A product of a total quantity of main decoding signals from all row decoders corresponding to a single memory array tile and the second quantity is the same as a quantity of word lines of the single memory array tile.

Each memory array tile corresponds to at least one sub-wordline driver, and each of the at least one sub-wordline driver provides multiple drive ports, and is configured to drive a word line of the corresponding memory array tile based on the main decoding signal and the sub-decoding signal. A total quantity of drive ports of all sub-wordline drivers corresponding to the single memory array tile is the same as the quantity of word lines of the memory array tile. All of each of the at least one row decoder, the sub-decoder, and each of the at least one sub-wordline driver are disposed in the logic circuit chip.

In some examples, each memory array tile corresponds to four row decoders, projections of positions corresponding to four vertices of each memory array tile on the logic circuit chip are respectively located in regions in which the four row decoders corresponding to the memory array tile are located, and four memory array tiles adjacent in a cross shape share a row decoder disposed at a position corresponding to a central region of the four memory array tiles.

In some examples, row decoders disposed at positions corresponding to different vertices of the memory array tile correspond to different word line ranges; and row decoders disposed at positions corresponding to the same vertices of two memory array tiles separated by one memory array tile correspond to the same word line range.

In some examples, each section includes multiple memory array tiles sequentially arranged in a first direction.

In some examples, each memory array tile corresponds to four sub-wordline drivers.

For a memory array tile not located at an edge in each section, two sub-wordline drivers are disposed in a projection region of the memory array tile on the logic circuit chip.

For a memory array tile located at the edge in each section, three sub-wordline drivers are disposed in a projection region of the memory array tile on the logic circuit chip.

In some examples, for the memory array tile not located at the edge in each section, each sub-wordline driver disposed in the projection region of the memory array tile on the logic circuit chip is shared by the memory array tile and an adjacent memory array tile of the memory array tile, and different sub-wordline drivers are shared by different adjacent memory array tiles.

For the memory array tile located at the edge in each section, in the three sub-wordline drivers disposed in the projection region of the memory array tile on the logic circuit chip, one sub-wordline driver is shared by the memory array tile and an adjacent memory array tile of the memory array tile, and the other two sub-wordline drivers are only configured to drive a word line of the memory array tile.

In some examples, for the memory array tile not located at the edge in each section, each sub-wordline driver disposed in the projection region of the memory array tile on the logic circuit chip is located in the projection region, and is adjacent to one side of a projection region corresponding to the memory array tile sharing the sub-wordline driver.

In some examples, for the memory array tile not located at the edge in each section, each sub-wordline driver is connected to main decoding signal lines of two adjacent row decoders, and each of the adjacent row decoders is a row decoder shared by the memory array tile and the memory array tile sharing the sub-wordline driver.

In some examples, for the memory array tile located at the edge in each section, in the three sub-wordline drivers disposed in the projection region of the memory array tile on the logic circuit chip, the sub-wordline driver shared by the adjacent memory array tile is located in the projection region, and is adjacent to one side of a projection region corresponding to the adjacent memory array tile, and the other two sub-wordline drivers are located on the other side of the projection region.

In some examples, for the memory array tile located at the edge in each section, the sub-wordline driver shared by the adjacent memory array tile is connected to main decoding signal lines of two row decoders shared by the memory array tile and the adjacent memory array tile, and the other two sub-wordline drivers are connected to main decoding signal lines of the other two row decoders corresponding to the memory array tile.

In some examples, each sub-wordline driver includes two sub-wordline driver units, and quantities of drive ports of the two sub-wordline driver units are the same.

In some examples, each of the sub-decoding signal lines is parallel to the first direction, and each of the main decoding signal lines is perpendicular to the first direction.

This application provides a memory. The memory includes a memory array chip and a logic circuit chip that are bonded. The logic circuit chip is located above the memory array chip. A memory array tile is disposed in the memory array chip. A row decoder, a sub-decoder, and a sub-wordline driver are disposed in the logic circuit chip. Compared with a planar memory structure, such an arrangement provides more circuit layout space, and there is no need to dispose the row decoder and the sub-wordline driver at a periphery of the memory array tile. This can effectively reduce a length of a signal line, reduce a delay, and improve performance of the memory. At least one corresponding row decoder and at least one sub-wordline driver are disposed for each memory array tile, to control a word line of each memory array tile. A product of a total quantity of main decoding signals from all row decoders corresponding to a single memory array tile and a second quantity is equal to a quantity of word lines of the single memory array tile. This can effectively decrease a quantity of main decoding signal lines corresponding to the memory array tile, alleviate limitations on a width and a spacing of the main decoding signal line, and lower routing difficulty.

### BRIEF DESCRIPTION OF DRAWINGS

The accompanying drawings herein, which are incorporated into and constitute a part of the specification, illustrate embodiments conforming to this application, and are utilized together with the specification to explain the principles of this application.
FIG. 1 is an example schematic structural diagram of a memory;
FIG. 2 is an example schematic structural diagram of a memory according to an embodiment of this application;
FIG. 3 is an example schematic structural diagram of another memory according to an embodiment of this application;
FIG. 4 is an example schematic structural diagram of still another memory according to an embodiment of this application;
FIG. 5 is an example schematic structural diagram of still another memory according to an embodiment of this application;
FIG. 6 is an example schematic structural diagram of still another memory according to an embodiment of this application;
FIG. 7 is an example schematic structural diagram of still another memory according to an embodiment of this application;
FIG. 8 is an example schematic structural diagram of still another memory according to an embodiment of this application;
FIG. 9 is an example schematic structural diagram of still another memory according to an embodiment of this application; and
FIG. 10 is an example schematic structural diagram of still another memory according to an embodiment of this application.

The foregoing accompanying drawings show specific embodiments of this application, which are described in more detail below. These accompanying drawings and text descriptions are not intended to limit the scope of the concept of this application in any manner, but to describe the concept of this application for a person skilled in the art with reference to specific embodiments.

### DESCRIPTION OF EMBODIMENTS

Example embodiments are described herein in detail, and examples thereof are shown in the accompanying drawings. When the following descriptions relate to the accompanying drawings, unless otherwise indicated, the same numbers in different accompanying drawings represent the same or similar elements. Implementations described in the following example embodiments do not represent all implementations consistent with this application. On the contrary, they are merely examples of apparatuses and methods that are consistent with some aspects of this application as detailed in the appended claims.

Nouns in this application are first explained.

Wafer-on-wafer (WoW) structure: In a preparation process of a three-dimensional memory device, two different wafers are usually bonded together to obtain a memory device, which is referred to as a wafer-on-wafer structure. The two wafers respectively include different semiconductor structures. One of the wafers is referred to as a memory array wafer, and the memory array wafer includes a semiconductor structure of a memory cell that performs storage. The other wafer is referred to as a logic circuit wafer (CMOS Wafer), and may also be referred to as a complementary metal oxide semiconductor (CMOS) wafer. The logic circuit wafer includes a peripheral circuit configured to perform signal transmission to a memory cell. The manufactured memory array wafer and logic circuit wafer are cut and packaged to obtain a memory array chip and a logic circuit chip.

Memory array tile: Each memory array tile includes multiple memory cells arranged in an array, and each memory cell is connected to one word line and one bit line.

Bank: Each bank includes multiple sections, and each section includes one row of memory array tiles.

A semiconductor memory device includes multiple memory array tiles, and each memory array tile includes memory cells arranged in an array. During reading of information from a memory, a memory cell address code corresponding to the to-be-read information needs to be obtained, and then a corresponding memory cell row code is read based on the memory cell address code, and a corresponding word line is activated based on the memory cell row code. After the word line is activated, a memory cell connected to the word line is in a readable/writable state. Correspondingly, a row decoder, a sub-decoder, and a sub-wordline driver are disposed in the memory. The row decoder is configured to generate a main decoding signal based on a first part of the memory cell address code. The sub-decoder is configured to generate a sub-decoding signal based on a second part of the memory cell address code. The sub-wordline driver is connected to the row decoder, the sub-decoder, and the word line, and is configured to drive the corresponding word line based on the main decoding signal and the sub-decoding signal.

In actual application, a main decoding signal line needs to traverse an entire section to be connected to all memory array tiles, and an excessively long routing length of the row decoder is caused because the row decoder is disposed on a single side. Consequently, delays for the main decoding signal output by the row decoder to arrive at the memory array tiles are different, and there is an excessively large delay difference in receiving the main decoding signal between a sub-wordline driver corresponding to a memory array tile close to the row decoder and a sub-wordline driver corresponding to a memory array tile far away from the row decoder, resulting in relatively poor timing uniformity. There are a relatively large quantity of main decoding signals, and for each main decoding signal, one main decoding signal line is required to transmit the main decoding signal from the row decoder to the sub-wordline driver. As the area of the semiconductor memory device decreases, a width and a spacing of the main decoding signal line are limited, resulting in difficulty in routing.

Example descriptions of the technical solutions of this application are provided below by utilizing specific embodiments. The following several specific embodiments may be combined with each other. The same or similar concept or process may not be described in some embodiments. The embodiments of the present disclosure are described below with reference to the accompanying drawings.

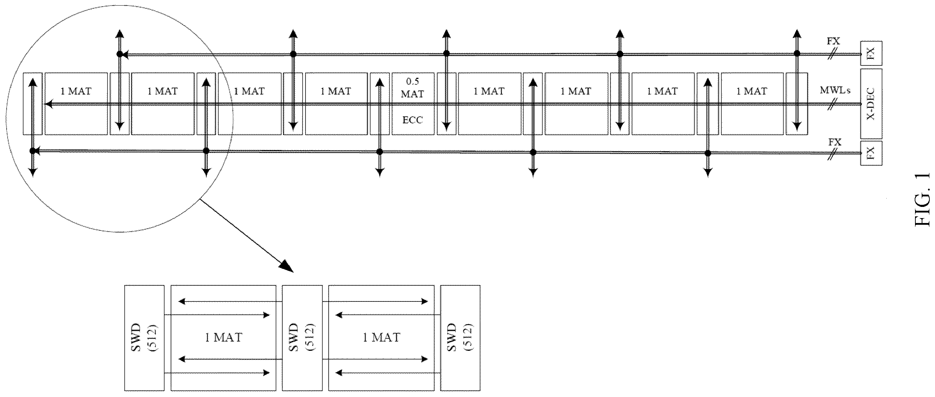

FIG. 1 is an example schematic structural diagram of a memory. As shown in FIG. 1, a planar process is utilized for the memory, and each section in the memory includes multiple sequentially arranged memory array tiles. The memory array tile may include a special memory array tile, that is, error checking and correcting (ECC), and a size of the ECC is half of a size of another memory array tile. One row decoder and two sub-decoders are correspondingly disposed on one side of each section, and one sub-wordline driver is separately disposed on either side of each memory array tile.

The row decoder generates n1 main decoding signals based on a first part of a memory cell address code, and separately transmits the n1 main decoding signals to each sub-wordline driver through n1 main decoding signal lines passing through the section. Each of the sub-decoders generates n2 sub-decoding signals based on a second part of the memory cell address code, and separately transmits the n2 sub-decoding signals to each sub-wordline driver through n2 sub-decoding signal lines passing through the section. Each memory array tile corresponds to n1*n2*2 word lines, which are respectively controlled by two sub-wordline drivers located on two sides of the memory array tile.

In actual application, a quantity of main decoding signals is usually greater than a quantity of sub-decoding signals. For example, if a size of the memory array tile is 1 kB, n1 may be 128, n2 may be 8, and 128 main decoding signal lines need to be disposed on each memory array tile. Therefore, a problem in this solution is that both a width and a spacing of the main decoding signal line are limited, and routing difficulty is relatively high. Further, because the row decoder is located on one side of the section, and the main decoding signal needs to be provided for each sub-wordline driver corresponding to the section, a transmission delay of the worst transmission path from the row decoder to the sub-wordline driver is relatively large, and there is a relatively large delay difference between the best transmission path and the worst transmission path, affecting timing and performance of the memory.

Some aspects of the embodiments of the present disclosure relate to the foregoing considerations. Example descriptions of the solutions are provided below with reference to some embodiments.

A memory provided in an embodiment of this application includes a memory array chip and a logic circuit chip that are bonded. The logic circuit chip is located above the memory array chip. Multiple sections arranged in an array are disposed in the memory array chip, and each section includes multiple memory array tiles.

Each memory array tile corresponds to at least one row decoder, each row decoder provides a first quantity of main decoding signal lines, and each of the main decoding signal lines is configured to transmit a main decoding signal. Each section corresponds to one sub-decoder, the sub-decoder provides a second quantity of sub-decoding signal lines, and each of the sub-decoding signal lines is configured to transmit a sub-decoding signal. A product of a total quantity of main decoding signals from all row decoders corresponding to a single memory array tile and the second quantity is the same as a quantity of word lines of the single memory array tile.

Each memory array tile corresponds to at least one sub-wordline driver, and each of the at least one sub-wordline driver provides multiple drive ports, and is configured to drive a word line of the corresponding memory array tile based on the main decoding signal and the sub-decoding signal. A total quantity of drive ports of all sub-wordline drivers corresponding to the single memory array tile is the same as the quantity of word lines of the memory array tile. All of each of the at least one row decoder, the sub-decoder, and each of the at least one sub-wordline driver are disposed in the logic circuit chip.

In actual application, the memory structure provided in this embodiment may be applied to multiple types of memories. In an example, the memory structure may be applied to a dynamic random access memory (DRAM).

Specifically, the memory in this example includes a memory array chip and a logic circuit chip that are bonded. The logic circuit chip is located above the memory array chip. The memory array chip is provided with multiple sections arranged in an array, where each of the sections includes multiple memory array tiles, and may be further provided with some cylindrical capacitor (Ni-Cap) circuits. The logic circuit chip is provided with a row decoder, a sub-decoder, and a sub-wordline driver, and may be further provided with a bit line sense amplifier (BLSA) and another peripheral (Peri) circuit. Compared with a planar memory structure, this structure provides more circuit layout space. There is no need to dispose the row decoder and the sub-wordline driver at a periphery of the memory array tile, and a distance between the row decoder and the sub-wordline driver and a distance between the sub-wordline driver and the memory array tile may be shortened based on a requirement. This helps optimize signal transmission paths from the row decoder to the sub-wordline driver and from the sub-wordline driver to a word line of the memory array tile, reduces a signal transmission delay, and helps improve performance of the memory.

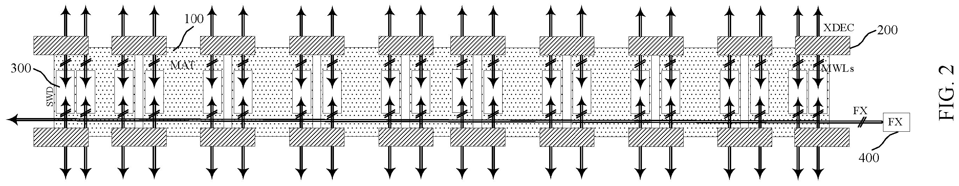

FIG. 2 is a schematic structural diagram of a memory according to an embodiment of this application. Only a top view of a structure of one section in the memory and a logic circuit corresponding to the section is shown. As shown in FIG. 2, one section includes multiple memory array tiles 100. Each memory array tile 100 corresponds to at least one row decoder 200, and each row decoder 200 provides a first quantity of main decoding signal lines, and transmits a main decoding signal to a sub-wordline driver 300 corresponding to the memory array tile through each of the main decoding signal lines. Each section corresponds to one sub-decoder 400, and the sub-decoder 400 provides a second quantity of sub-decoding signal lines, and transmits a sub-decoding signal to the sub-wordline driver 300 corresponding to the memory array tile through each of the sub-decoding signal lines. A product of a total quantity of main decoding signals from all row decoders 200 corresponding to a single memory array tile 100 and the second quantity is the same as a quantity of word lines of the single memory array tile 100. Each word line of the memory array tile 100 can be controlled based on the total quantity of main decoding signals generated by all the row decoders 200 corresponding to the single memory array tile 100 and a sub-decoding signal generated by a sub-decoder 400 corresponding to the single memory array tile 100.

The word line of the memory array tile 100 is usually controlled through the sub-wordline driver 300. In this example, each memory array tile 100 corresponds to at least one sub-wordline driver 300, and each sub-wordline driver 300 provides multiple drive ports, and is configured to drive a word line of the corresponding memory array tile 100 based on the main decoding signal and the sub-decoding signal. Different drive ports correspond to different word lines of the memory array tile 100, and a total quantity of drive ports of all sub-wordline drivers 300 corresponding to the single memory array tile 100 is the same as the quantity of word lines of the memory array tile 100. Therefore, all the sub-wordline drivers 300 corresponding to the single memory array tile 100 can correspondingly drive all word lines of the memory array tile 100. By setting that each memory array tile 100 corresponds to at least one row decoder 200 and at least one sub-wordline driver 300, main decoding signals required for controlling word lines of each memory array tile 100 are allowed to be jointly generated by multiple row decoders 200, and the word lines of the memory array tile 100 are allowed to be controlled by multiple sub-wordline drivers 300. This helps decrease a quantity of main decoding signal lines, and improves layout flexibility of the memory.

In this example, the memory includes a memory array chip and a logic circuit chip that are bonded. The logic circuit chip is located above the memory array chip. A memory array tile is disposed in the memory array chip. A row decoder, a sub-decoder, and a sub-wordline driver are disposed in the logic circuit chip. This can effectively reduce a length of a signal line, reduce a delay, and improve performance of the memory. At least one corresponding row decoder and at least one sub-wordline driver are disposed for each memory array tile, to control a word line of each memory array tile. A product of a total quantity of main decoding signals from all row decoders corresponding to a single memory array tile and a second quantity is equal to a quantity of word lines of the single memory array tile. This can effectively decrease a quantity of main decoding signal lines corresponding to the memory array tile, alleviate limitations on a width and a spacing of the main decoding signal line, and lower routing difficulty.

In actual application, a quantity of row decoders corresponding to each memory array tile may be selected based on a production requirement. In an example, each memory array tile corresponds to four row decoders, projections of positions corresponding to four vertices of each memory array tile on the logic circuit chip are respectively located in regions in which the four row decoders corresponding to the memory array tile are located, and four memory array tiles adjacent in a cross shape share a row decoder disposed at a position corresponding to a central region of the four memory array tiles.

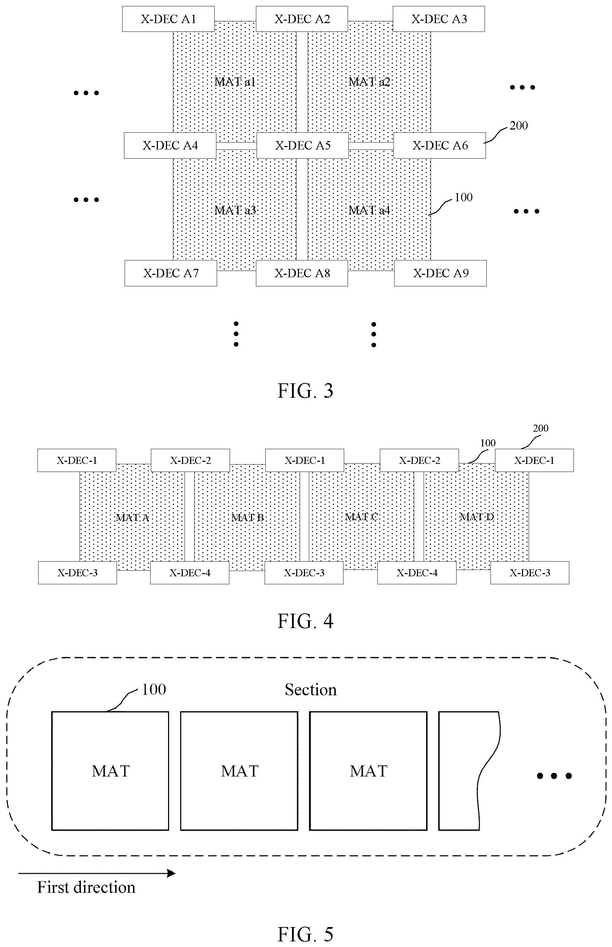

Specifically, each memory array tile corresponds to four row decoders, the four row decoders are disposed around the memory array tile, and projections of positions corresponding to four vertices of each memory array tile on the logic circuit chip are respectively located in regions in which the four row decoders corresponding to the memory array tile are located. In addition, to avoid repeatedly disposing a row decoder, the row decoder may be shared by adjacent memory array tiles. Every four memory array tiles adjacent in a cross shape share one row decoder, and the row decoder is located in a projection region, on the logic circuit chip, of a central region of the four memory array tiles adjacent in a cross shape. The four memory array tiles adjacent in a cross shape are arranged in a form of a 2*2 array, and any two of the memory array tiles are adjacent. In actual application, a quantity of row decoders corresponding to each memory array tile may be selected based on a production requirement. FIG. 3 is a schematic structural diagram of another memory according to an embodiment of this application. FIG. 3 is a top view of the memory. In actual application, the memory array tile 100 is located in the lower memory array chip, and the row decoder 200 is located in the upper logic circuit chip. As shown in FIG. 3, in an example, each memory array tile 100 corresponds to four row decoders 200. For example, a memory array tile MAT a1 corresponds to four row decoders X-DEC A1, X-DEC A2, X-DEC A4, and X-DEC A5, and projection regions of four vertices of the memory array tile MAT a1 on the logic circuit chip are respectively located in regions in which the four row decoders X-DEC A1, X-DEC A2, X-DEC A4, and X-DEC A5 are located. In addition, four memory array tiles MAT a1, MAT a2, MAT a3, and MAT a4 adjacent in a cross shape share the row decoder X-DEC A5, and the row decoder X-DEC A5 is located at a position corresponding to a central region of an entirety of the four memory array tiles MAT a1, MAT a2, MAT a3, and MAT a4 adjacent in a cross shape.

Based on the foregoing example, to enable the row decoders corresponding to each memory array tile to jointly generate main decoding signals required for controlling word lines of the memory array tile, in an example, row decoders disposed at positions corresponding to different vertices of the memory array tile correspond to different word line ranges; and row decoders disposed at positions corresponding to the same vertices of two memory array tiles separated by one memory array tile correspond to the same word line range.

Specifically, the four row decoders corresponding to each memory array tile correspond to four word line ranges. Based on the word line ranges corresponding to the row decoders, the row decoders may be classified into four types: a first row decoder, a second row decoder, a third row decoder, and a fourth row decoder. Row decoders of the same type simultaneously work, and generate the same main decoding signal through decoding. To enable each memory array tile to correspond to four different row decoders, row decoders of different types are disposed in a structure of being distributed at intervals, and row decoders disposed at positions corresponding to the same vertices of two memory array tiles separated by one memory array tile correspond to the same word line range. A region in which a row decoder disposed at a position corresponding to a vertex of the memory array tile is located includes a projection, on the logic circuit chip, of a position at which the vertex is located.

FIG. 4 is a schematic structural diagram of still another memory according to an embodiment of this application. As shown in FIG. 4, four corresponding row decoders 200 are disposed in each memory array tile 100, and specifically include a first row decoder X-DEC-1, a second row decoder X-DEC-2, a third row decoder X-DEC-3, and a fourth row decoder X-DEC-4. For a memory array tile MAT A and a memory array tile MAT C that are separated by one memory array tile MAT B, a projection of an upper left vertex of the memory array tile MAT A on the logic circuit chip is located in a region in which a first row decoder X-DEC-1 corresponding to the memory array tile MAT A is located, and correspondingly, a projection of an upper left vertex of the memory array tile MAT C on the logic circuit chip is located in a region in which a first row decoder X-DEC-1 corresponding to the memory array tile MAT C is located. Similarly, a projection of an upper right vertex of the memory array tile MAT A on the logic circuit chip is located in a region in which a second row decoder X-DEC-2 corresponding to the memory array tile MAT A is located, and correspondingly, a projection of an upper right vertex of the memory array tile MAT C on the logic circuit chip is located in a region in which a second row decoder X-DEC-2 corresponding to the memory array tile MAT C is located; a projection of a lower left vertex of the memory array tile MAT A on the logic circuit chip is located in a region in which a third row decoder X-DEC-3 corresponding to the memory array tile MAT A is located, and correspondingly, a projection of a lower left vertex of the memory array tile MAT C on the logic circuit chip is located in a region in which a third row decoder X-DEC-3 corresponding to the memory array tile MAT C is located; and a projection of a lower right vertex of the memory array tile MAT A on the logic circuit chip is located in a region in which a fourth row decoder X-DEC-4 corresponding to the memory array tile MAT A is located, and correspondingly, a projection of a lower right vertex of the memory array tile MAT C on the logic circuit chip is located in a region in which a fourth row decoder X-DEC-4 corresponding to the memory array tile MAT C is located. There is a similar case for the memory array tile B and a memory array tile D. Details are not described herein again.

In this example, it is set that the row decoders corresponding to each memory array tile correspond to different word line ranges, and it is set that row decoders disposed at positions corresponding to the same angles of two memory array tiles separated by one memory array tile correspond to the same word line range, so that all the row decoders corresponding to each memory array tile can cooperatively generate main decoding signals required for controlling all the word lines of the memory array tile, to allow each row decoder to generate only some main decoding signals. This helps reduce volumes of the row decoder and the memory.

To reduce a word line range corresponding to each sub-wordline driver and improve flexibility of disposing the sub-wordline driver, in an example, each memory array tile corresponds to four sub-wordline drivers.

For a memory array tile not located at an edge in each section, two sub-wordline drivers are disposed in a projection region of the memory array tile on the logic circuit chip.

For a memory array tile located at the edge in each section, three sub-wordline drivers are disposed in a projection region of the memory array tile on the logic circuit chip.

There may be multiple structures of the section. In an example, each section includes multiple memory array tiles sequentially arranged in a first direction.

In actual application, each memory includes multiple banks, and each bank includes multiple sections. FIG. 5 is a schematic structural diagram of a section according to an embodiment of this application. As shown in FIG. 5, each section includes multiple memory array tiles 100 sequentially arranged in a first direction shown in the figure.

Specifically, each memory array tile corresponds to four sub-wordline drivers, and each sub-wordline driver controls a quarter of word lines of the memory array tile. For a memory array tile not located at an edge in each section, two sub-wordline drivers are disposed in a projection region of the memory array tile on the logic circuit chip. For a memory array tile located at the edge in each section, three sub-wordline drivers are disposed in a projection region of the memory array tile on the logic circuit chip.

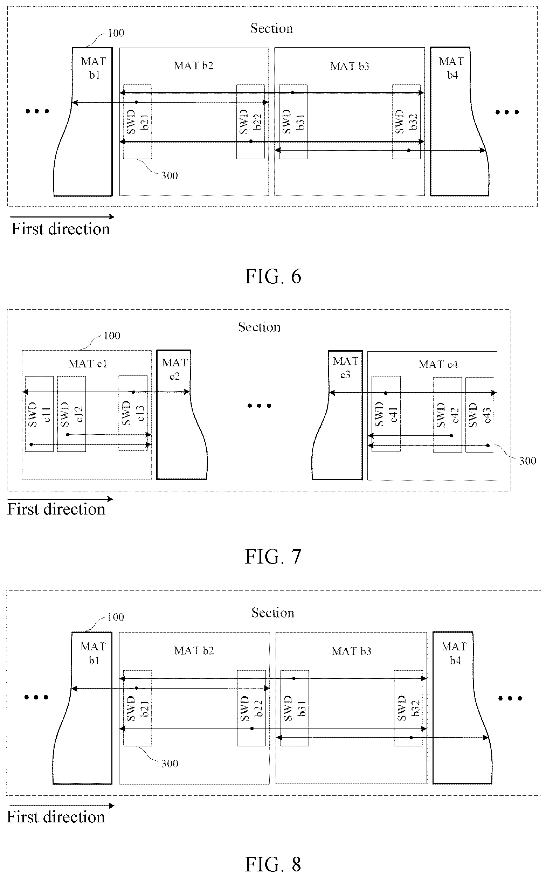

FIG. 6 is a schematic structural diagram of still another memory according to an embodiment of this application. As shown in FIG. 6, a memory array tile MAT b2 and a memory array tile MAT b3 are two adjacent memory array tiles 100 not located at an edge in the section, two sub-wordline drivers SWD b21 and SWD b22 are disposed in a projection region of the memory array tile MAT b2 on the logic circuit chip, and two sub-wordline drivers SWD b31 and SWD b32 are disposed in a projection region of the memory array tile MAT b3 on the logic circuit chip.

FIG. 7 is a schematic structural diagram of still another memory according to an embodiment of this application. As shown in FIG. 7, a memory array tile MAT c1 and a memory array tile MAT c4 are two memory array tiles located at an edge in the section, three sub-wordline drivers SWD c11, SWD c12, and SWD c13 are disposed in a projection region of the memory array tile MAT c1 on the logic circuit chip, and three sub-wordline drivers SWD c41, SWD c42, and SWD c43 are disposed in a projection region of the memory array tile MAT c4 on the logic circuit chip.

In this example, it is set that each memory array tile corresponds to four sub-wordline drivers, so that the four sub-wordline drivers can jointly drive word lines of each memory array tile. This improves flexibility of disposing the sub-wordline driver.

Based on the foregoing example memory structure, it may be set that a sub-wordline driver is shared by multiple memory array tiles. This can optimize a layout of the memory, and help further reduce the volume of the memory. In an example, for the memory array tile not located at the edge in each section, each sub-wordline driver disposed in the projection region of the memory array tile on the logic circuit chip is shared by the memory array tile and an adjacent memory array tile of the memory array tile, and different sub-wordline drivers are shared by different adjacent memory array tiles.

For the memory array tile located at the edge in each section, in the three sub-wordline drivers disposed in the projection region of the memory array tile on the logic circuit chip, one sub-wordline driver is shared by the memory array tile and an adjacent memory array tile of the memory array tile, and the other two sub-wordline drivers are only configured to drive a word line of the memory array tile.

Specifically, the sub-wordline driver can be shared only by memory array tiles belonging to the same section, and cannot be shared by memory array tiles belonging to different sections. Therefore, based on a structure of the section, memory array tiles in the section may be classified into two cases for discussion.

In the first case, for the memory array tile not located at the edge in each section, each of the two sub-wordline drivers disposed in the projection region of the memory array tile on the logic circuit chip is shared by the memory array tile and an adjacent memory array tile of the memory array tile, and the two sub-wordline drivers are shared by two different adjacent memory array tiles.

Still as shown in FIG. 6, the sub-wordline driver SWD b21 is shared by the memory array tile MAT b2 and a memory array tile MAT b1 adjacent to the memory array tile MAT b2, the sub-wordline driver SWD b22 is shared by the memory array tile MAT b2 and the memory array tile MAT b3 adjacent to the memory array tile MAT b2, the sub-wordline driver SWD b31 is shared by the memory array tile MAT b3 and the memory array tile MAT b2 adjacent to the memory array tile MAT b3, and the sub-wordline driver SWD b32 is shared by the memory array tile MAT b3 and a memory array tile MAT b4 adjacent to the memory array tile MAT b3.

For the memory array tile located at the edge in each section, in the three sub-wordline drivers disposed in the projection region of the memory array tile on the logic circuit chip, one sub-wordline driver is shared by the memory array tile and an adjacent memory array tile of the memory array tile, and the other two sub-wordline drivers are only configured to drive a word line of the memory array tile.

Still as shown in FIG. 7, the sub-wordline drivers SWD c11 and SWD c12 are not shared by multiple memory array tiles 100, and drive only a word line of the memory array tile MAT c1, the sub-wordline driver SWD c13 is shared by the memory array tile MAT c1 and a memory array tile MAT c2 adjacent to the memory array tile MAT c1, the sub-wordline driver SWD c41 is shared by the memory array tile MAT c4 and a memory array tile MAT c3 adjacent to the memory array tile MAT c4, and the sub-wordline drivers SWD c42 and SWD c43 are not shared by multiple memory array tiles 100, and drive only a word line of the memory array tile MAT c4.

In this example, it is set that different memory array tiles share a sub-wordline driver, each sub-wordline driver disposed in the projection region of the memory array tile not located at the edge in the section on the logic circuit chip is shared by the memory array tile and an adjacent memory array tile of the memory array tile, and in the three sub-wordline drivers disposed in the projection region of the memory array tile located at the edge in the section on the logic circuit chip, one sub-wordline driver is shared by the memory array tile and an adjacent memory array tile of the memory array tile, and the other two sub-wordline drivers are only configured to drive a word line of the memory array tile. This effectively reduces a word line range driven by each sub-wordline driver, thereby reducing the volume of the sub-wordline driver, helping optimize an internal layout of the memory, and reducing the volume of the memory.

Based on the foregoing example, when it is set that the sub-wordline driver is shared by multiple memory array tiles, to shorten a signal transmission path from the sub-wordline driver to the word line of the memory array tile, it may be set that the sub-wordline driver is shared by adjacent memory array tiles. In an example, for the memory array tile not located at the edge in each section, each sub-wordline driver disposed in the projection region of the memory array tile on the logic circuit chip is located in the projection region, and is adjacent to one side of a projection region corresponding to the memory array tile sharing the sub-wordline driver.

Specifically, for the memory array tile not located at the edge in each section, the two sub-wordline drivers are sequentially disposed in the projection region of the memory array tile on the logic circuit chip in the first direction, and each sub-wordline driver is adjacent to one side of the projection region, on the logic circuit chip, corresponding to the memory array tile sharing the sub-wordline driver.

Still as shown in FIG. 6, for the memory array tile MAT b2 not located at the edge in the section, the two sub-wordline drivers SWD b21 and SWD b22 are sequentially disposed in a projection region of the memory array tile MAT b2 on the logic circuit chip in the first direction. The sub-wordline driver SWD b21 is shared by the memory array tile MAT b2 and the memory array tile MAT b1 adjacent to the memory array tile MAT b2, and the sub-wordline driver SWD b22 is shared by the memory array tile MAT b2 and the memory array tile MAT b3 adjacent to the memory array tile MAT b2. Correspondingly, the sub-wordline driver SWD b21 is located on one side of a projection region corresponding to the memory array tile MAT b1 on the logic circuit chip, and the sub-wordline driver SWD b22 is located on one side of a projection region corresponding to the memory array tile MAT b3 on the logic circuit chip.

In this example, for the memory array tile not located at the edge in the section, the sub-wordline driver in the projection region of the memory array tile on the logic circuit chip is shared by the memory array tile and a memory array tile adjacent to the sub-wordline driver in the projection region on the logic circuit chip. This effectively shortens a distance between the sub-wordline driver and a word line correspondingly driven by the sub-wordline driver, thereby reducing a delay of word line driving, and helping optimize performance of the memory.

In addition to shortening the signal transmission path from the sub-wordline driver to the word line of the memory array tile, a signal transmission path from the row decoder to the sub-wordline driver may be further shortened, to help further improve the performance of the memory. In an example, for the memory array tile not located at the edge in each section, each sub-wordline driver is connected to main decoding signal lines of two adjacent row decoders, and each of the adjacent row decoders is a row decoder shared by the memory array tile and the memory array tile sharing the sub-wordline driver.

Specifically, for the memory array tile not located at the edge in each section, each sub-wordline driver is connected to main decoding signal lines of two adjacent row decoders, and each of the adjacent row decoders is a row decoder shared by the memory array tile and the memory array tile sharing the sub-wordline driver.

FIG. 8 is a schematic structural diagram of still another memory according to an embodiment of this application. As shown in FIG. 8, for a memory array tile MAT b2 not located at the edge in the section, two sub-wordline drivers SWD b21 and SWD b22 are sequentially disposed in a projection region of the memory array tile MAT b2 on the logic circuit chip in the first direction. The sub-wordline driver SWD b21 is shared by the memory array tile MAT b2 and a memory array tile MAT b1 adjacent to the memory array tile MAT b2, and the sub-wordline driver SWD b22 is shared by the memory array tile MAT b2 and a memory array tile MAT b3 adjacent to the memory array tile MAT b2. The memory array tile MAT b2 corresponds to four row decoders XDEC d1, XDEC d2, XDEC d4, and XDEC d5. The memory array tile MAT b2 and the adjacent memory array tile MAT b1 share the row decoders XDEC d1 and XDEC d4, and the memory array tile MAT b2 and the adjacent memory array tile MAT b3 share the row decoders XDEC d2 and XDEC d5. In this case, the sub-wordline driver SWD b21 is connected to main decoding signal lines of the two adjacent row decoders XDEC d1 and XDEC d4, and the sub-wordline driver SWD b22 is connected to main decoding signal lines of the two adjacent row decoders XDEC d2 and XDEC d5.

In this example, for the memory array tile not located at the edge in each section, it is set that each sub-wordline driver is connected to the main decoding signal lines of the two row decoders shared by the memory array tile and the memory array tile sharing the sub-wordline driver, so that each sub-wordline driver can be connected to the row decoders adjacent to the sub-wordline driver, to shorten a transmission path from the row decoder to the sub-wordline driver. This helps increase a speed of driving the word line in the memory, and effectively improves the performance of the memory.

Correspondingly, for the memory array tile located at the edge in the section, it may also be set that the sub-wordline driver in the projection region of the memory array tile on the logic circuit chip is shared by multiple memory array tiles, to optimize a layout of the memory. In an example, for the memory array tile located at the edge in each section, in the three sub-wordline drivers disposed in the projection region of the memory array tile on the logic circuit chip, the sub-wordline driver shared by the adjacent memory array tile is located in the projection region, and is adjacent to one side of a projection region corresponding to the adjacent memory array tile, and the other two sub-wordline drivers are located on the other side of the projection region.

Specifically, for the memory array tile located at the edge in each section, in the three sub-wordline drivers disposed in the projection region of the memory array tile on the logic circuit chip, the sub-wordline driver shared by the adjacent memory array tile is located in the projection region, and is adjacent to one side of a projection region corresponding to the adjacent memory array tile, and the other two sub-wordline drivers are located on the other side of the projection region.

Still as shown in FIG. 7, for the memory array tile MAT c1 located at the edge in the section, the three sub-wordline drivers SWD c11, SWD c12, and SWD c13 are disposed in a projection region of the memory array tile MAT c1 on the logic circuit chip. The sub-wordline drivers SWD c11 and SWD c12 are not shared, and drive only the word line of the memory array tile MAT c1, and the sub-wordline driver SWD c13 is shared by the memory array tile MAT c1 and the memory array tile MAT c2 adjacent to the memory array tile MAT c1. Correspondingly, the sub-wordline driver SWD c13 is located on one side of a projection region corresponding to the adjacent memory array tile MAT c2, and the sub-wordline drivers SWD c11 and SWD c12 are located on the other side of the projection region.

In this example, for the memory array tile located at the edge in the section, in the three sub-wordline drivers disposed in the projection region of the memory array tile on the logic circuit chip, the sub-wordline driver shared by the adjacent memory array tile is located in the projection region, and is adjacent to one side of a projection region corresponding to the adjacent memory array tile, and the other two sub-wordline drivers are located on the other side of the projection region. This effectively shortens a distance between the sub-wordline driver and a word line correspondingly driven by the sub-wordline driver, thereby reducing a delay of word line driving, and helping optimize performance of the memory.

Based on the foregoing example, a signal transmission path from the row decoder to the sub-wordline driver may be further shortened, to help further improve the performance of the memory. In an example, for the memory array tile located at the edge in each section, the sub-wordline driver shared by the adjacent memory array tile is connected to main decoding signal lines of two row decoders shared by the memory array tile and the adjacent memory array tile, and the other two sub-wordline drivers are connected to main decoding signal lines of the other two row decoders corresponding to the memory array tile.

Specifically, for the memory array tile located at the edge in each section, the sub-wordline driver shared by the adjacent memory array tile is connected to main decoding signal lines of two row decoders shared by the memory array tile and the adjacent memory array tile, and the other two sub-wordline drivers are connected to main decoding signal lines of the other two row decoders corresponding to the memory array tile.

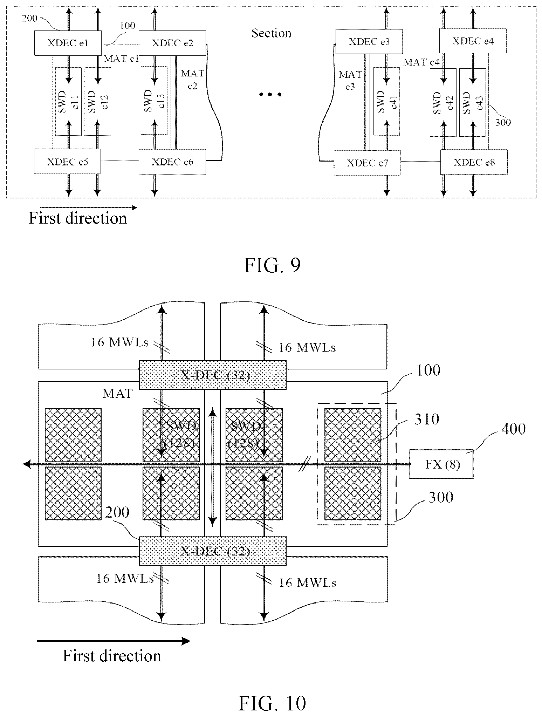

FIG. 9 is a schematic structural diagram of still another memory according to an embodiment of this application. As shown in FIG. 9, for a memory array tile MAT c1 located at the edge in the section, three sub-wordline drivers SWD c11, SWD c12, and SWD c13 are disposed in a projection region of the memory array tile MAT c1 on the logic circuit chip. The sub-wordline drivers SWD c11 and SWD c12 drive only a word line of the memory array tile MAT c1, and the sub-wordline driver SWD c13 is shared by the memory array tile MAT c1 and a memory array tile MAT c2 adjacent to the memory array tile MAT c1. The memory array tile MAT c1 corresponds to four row decoders XDEC e1, XDEC e2, XDEC e5, and XDEC e6. The row decoders XDEC e2 and XDEC e6 are shared by the memory array tile MAT c1 and the memory array tile MAT c2 adjacent to the memory array tile MAT c1. Correspondingly, the sub-wordline driver SWD c13 is connected to main decoding signal lines of the row decoders XDEC e2 and XDEC e6, and the sub-wordline drivers SWD c11 and SWD c12 are connected to main decoding signal lines of the row decoders XDEC e1 and XDEC e5.

In this example, for the memory array tile located at the edge in each section, it is set that the sub-wordline driver shared by the adjacent memory array tile is connected to the main decoding signal lines of the two row decoders shared by the memory array tile and the adjacent memory array tile, and the other two sub-wordline drivers are connected to the main decoding signal lines of the other two row decoders corresponding to the memory array tile, so that each sub-wordline driver can be connected to the row decoders adjacent to the sub-wordline driver, to shorten a transmission path from the row decoder to the sub-wordline driver. This helps increase a speed of driving the word line in the memory, and effectively improves the performance of the memory.

Based on the foregoing example, each sub-wordline driver receives main decoding signals sent by two row decoders. Therefore, each sub-wordline driver may be divided into two sub-wordline driver units, and each sub-wordline driver unit is connected to a main decoding signal line of one corresponding row decoder. In an example, each sub-wordline driver includes two sub-wordline driver units, and quantities of drive ports of the two sub-wordline driver units are the same.

Specifically, each sub-wordline driver includes two sub-wordline driver units, and quantities of drive ports of the two sub-wordline driver units are the same. For example, each sub-wordline driver includes 256 drive ports respectively controlling 256 word lines of each memory array tile corresponding to the sub-wordline driver. Each sub-wordline driver includes two sub-wordline driver units, each sub-wordline driver unit includes 128 drive ports respectively controlling 128 word lines of each memory array tile corresponding to the sub-wordline driver unit, and the two sub-wordline driver units correspond to different word line ranges.

FIG. 10 is a schematic structural diagram of still another memory according to an embodiment of this application. As shown in FIG. 10, a memory array tile 100 not located at the edge in the section is taken as an example. Each memory array tile 100 includes two sub-wordline drivers 300, each sub-wordline driver 300 includes two sub-wordline driver units 310 arranged perpendicular to the first direction, and quantities of ports of all the sub-wordline driver units 310 are the same. The sub-wordline driver unit 310 disposed in a projection region of the memory array tile 100 on the logic circuit chip receives a main decoding signal sent by a row decoder 200 corresponding to the memory array tile 100, and each sub-wordline driver unit 310 receives a main decoding signal sent by an adjacent row decoder 200. It is assumed that each row decoder 200 generates 32 main decoding signals. When the main decoding signals are sent to corresponding sub-wordline driver units 310, 16 of the main decoding signals are sent to each corresponding sub-wordline driver unit 310 located on one side of the row decoder 200 in the first direction and the other 16 main decoding signals are sent to a corresponding sub-wordline driver unit 310 located on the other side of the row decoder 200 in the first direction through 16 main decoding signal lines. Each sub-wordline driver unit 310 receives 16 main decoding signals generated by one decoder 200, and with reference to eight sub-decoding signals that are sent by the sub-decoder 400 and that are received by the sub-wordline driver unit 310, each sub-wordline driver unit 310 can control 16*8=128 word lines of each corresponding memory array tile 100. Each memory array tile 100 corresponds to four sub-wordline drivers 300, that is, corresponds to eight sub-wordline driver units 310, and the eight sub-wordline driver units 310 correspond to different word line ranges. Therefore, the eight sub-wordline driver units 310 can jointly control 16*8*8=1024 word lines of the memory array tile 100.

One sub-wordline driver unit 310 sends 16 main decoding signals, and the two sub-wordline driver units corresponding to each sub-wordline driver receive main decoding signals generated by different row decoders.

The sub-wordline driver units corresponding to each sub-wordline driver may be arranged perpendicular to the first direction, and each sub-wordline driver unit receives a main decoding signal sent by an adjacent row decoder.

As shown in FIG. 2, based on the main decoding signal lines arranged perpendicular to the first direction, a transmission path from the row decoder to the sub-wordline driver is relatively short, and delays of transmission paths from all row decoders to the sub-wordline driver are basically the same. This helps increase a speed of driving the word line, and can optimize timing and a sensing margin of the memory.

Each of the main decoding signal lines is configured to connect the row decoder and the sub-wordline driver, and each of the sub-decoding signal lines is configured to connect the sub-decoder and the sub-wordline driver. In actual application, there may be multiple manners of routing each of the main decoding signal lines and each of the sub-decoding signal lines. To shorten the signal transmission path from the row decoder to the sub-wordline driver, in an example, each of the sub-decoding signal lines is parallel to the first direction, and each of the main decoding signal lines is perpendicular to the first direction.

Specifically, the logic circuit chip of the memory is located above the memory array chip, a routing layer and a device layer are disposed in the logic circuit chip, a main decoding signal line and a sub-decoding signal line are arranged at the routing layer, and a sub-wordline driver, a row decoder, and a sub-decoder are disposed at the device layer. The sub-decoding signal line is arranged parallel to the first direction at the routing layer, and passes down to the device layer to connect an output terminal of the sub-decoder and an input terminal of the sub-wordline driver. The main decoding signal line is arranged perpendicular to the first direction at the routing layer, and passes down to the device layer to connect an output terminal of the row decoder and the input terminal of the sub-wordline driver. As shown in FIG. 8 and FIG. 9, the main decoding signal line is perpendicular to the first direction and connects the row decoder 200 and the sub-wordline driver 300, to effectively shorten a signal transmission path from the row decoder 200 to the sub-wordline driver 300.

Based on this routing manner, as shown in FIG. 10, a memory array tile 100 not located at the edge in the section is taken as an example, and each memory array tile 100 includes two sub-wordline drivers 300. The sub-wordline driver 300 disposed in a projection region of the memory array tile 100 on the logic circuit chip receives a main decoding signal sent by a row decoder 200 corresponding to the memory array tile 100. It is assumed that each row decoder 200 generates 32 main decoding signals. When the main decoding signals are sent to corresponding sub-wordline drivers 300, 16 of the main decoding signals are sent to each corresponding sub-wordline driver 300 located on one side of the row decoder 200 in the first direction and the other 16 main decoding signals are sent to a corresponding sub-wordline driver 300 located on the other side of the row decoder 200 in the first direction through 16 main decoding signal lines. Each sub-wordline driver 300 receives 16 main decoding signals generated by each of two row decoders 200, and with reference to eight received sub-decoding signals sent by the sub-decoder 400, each sub-wordline driver 300 can control 16*2*8=256 word lines of each corresponding memory array tile 100. Each memory array tile 100 corresponds to four sub-wordline drivers 300, and the four sub-wordline drivers 300 correspond to different word line ranges. Therefore, the four sub-wordline drivers 300 can jointly control 16*2*8*4=1024 word lines of the memory array tile 100. A projection region of each memory array tile 100 on the logic circuit chip is divided into two sub-regions arranged perpendicular to the first direction, and only 32 parallel main decoding signal lines perpendicular to the first direction need to be separately disposed in each sub-region. Compared with a conventional manner in which 128 main decoding signal lines need to be disposed in each memory array tile 100, such an arrangement effectively alleviates limitations on a width and a spacing of the main decoding signal line, and lowers routing difficulty.

In the foregoing routing manner, while ordered routing is implemented, the signal transmission path from the row decoder to the sub-wordline driver can be shortened, a delay difference between different transmission paths can be reduced, and timing of the memory can be optimized.

This embodiment provides a memory. The memory includes a memory array chip and a logic circuit chip that are bonded. The logic circuit chip is located above the memory array chip. A memory array tile is disposed in the memory array chip. A row decoder, a sub-decoder, and a sub-wordline driver are disposed in the logic circuit chip. Compared with a planar memory structure, such an arrangement provides more circuit layout space, and there is no need to dispose the row decoder and the sub-wordline driver at a periphery of the memory array tile. This can effectively reduce a length of a signal line, reduce a delay, and improve performance of the memory. At least one corresponding row decoder and at least one sub-wordline driver are disposed for each memory array tile, to control a word line of each memory array tile. A product of a total quantity of main decoding signals from all row decoders corresponding to a single memory array tile and a second quantity is equal to a quantity of word lines of the single memory array tile. This can effectively decrease a quantity of main decoding signal lines corresponding to the memory array tile, alleviate limitations on a width and a spacing of the main decoding signal line, and lower routing difficulty.

A person skilled in the art can easily figure out other implementation solutions of this application after consideration of the specification and practice of the present invention disclosed herein. This application is intended to cover any variations, purposes, or adaptive changes of this application. These variations, purposes, or adaptive changes follow the general principles of this application and include common knowledge or conventional technical means in the art that are not disclosed in this application. The specification and embodiments are merely considered as examples, and the true scope and spirit of this application are pointed out in the following claims.

It should be understood that this application is not limited to the precise structures described above and shown in the accompanying drawings, and various modifications and changes may be made without departing from the scope thereof. The scope of this application is limited only by the appended claims.

## Claims

1. A memory, the memory comprising a memory array chip and a logic circuit chip that are bonded, the logic circuit chip being located above the memory array chip, a plurality of sections arranged in an array being disposed in the memory array chip, and each section comprising a plurality of memory array tiles (100);
each memory array tile corresponding to at least one row decoder (200), each row decoder providing a first quantity of main decoding signal lines, and each of the main decoding signal lines being configured to transmit a main decoding signal; each section corresponding to one sub-decoder (400), the sub-decoder providing a second quantity of sub-decoding signal lines, and each of the sub-decoding signal lines being configured to transmit a sub-decoding signal; and a product of a total quantity of main decoding signals from all row decoders corresponding to a single memory array tile and the second quantity being the same as a quantity of word lines of the single memory array tile; and
each memory array tile corresponding to at least one sub-wordline driver (300), and each of the at least one sub-wordline driver providing a plurality of drive ports, and being configured to drive a word line of the corresponding memory array tile based on the main decoding signal and the sub-decoding signal; a total quantity of drive ports of all sub-wordline drivers corresponding to the single memory array tile being the same as the quantity of word lines of the memory array tile; and all of each of the at least one row decoder, the sub-decoder, and each of the at least one sub-wordline driver being disposed in the logic circuit chip.

2. The memory according to claim 1, wherein each memory array tile corresponds to four row decoders, projections of positions corresponding to four vertices of each memory array tile on the logic circuit chip are respectively located in regions in which the four row decoders corresponding to the memory array tile are located, and four memory array tiles adjacent in a cross shape share a row decoder disposed at a position corresponding to a central region of the four memory array tiles.

3. The memory according to claim 2, wherein row decoders disposed at positions corresponding to different vertices of the memory array tile correspond to different word line ranges; and row decoders disposed at positions corresponding to same vertices of two memory array tiles separated by one memory array tile correspond to a same word line range.

4. The memory according to claim 3, wherein each section comprises a plurality of memory array tiles sequentially arranged in a first direction.

5. The memory according to claim 4, wherein each memory array tile corresponds to four sub-wordline drivers;
for a memory array tile not located at an edge in each section, two sub-wordline drivers are disposed in a projection region of the memory array tile on the logic circuit chip; and
for a memory array tile located at the edge in each section, three sub-wordline drivers are disposed in a projection region of the memory array tile on the logic circuit chip.

6. The memory according to claim 5, wherein for the memory array tile not located at the edge in each section, each sub-wordline driver disposed in the projection region of the memory array tile on the logic circuit chip is shared by the memory array tile and an adjacent memory array tile of the memory array tile, and different sub-wordline drivers are shared by different adjacent memory array tiles; and
for the memory array tile located at the edge in each section, in the three sub-wordline drivers disposed in the projection region of the memory array tile on the logic circuit chip, one sub-wordline driver is shared by the memory array tile and an adjacent memory array tile of the memory array tile, and the other two sub-wordline drivers are only configured to drive a word line of the memory array tile.

7. The memory according to claim 6, wherein for the memory array tile not located at the edge in each section, each sub-wordline driver disposed in the projection region of the memory array tile on the logic circuit chip is located in the projection region, and is adjacent to one side of a projection region corresponding to the memory array tile sharing the sub-wordline driver.

8. The memory according to claim 7, wherein for the memory array tile not located at the edge in each section, each sub-wordline driver is connected to main decoding signal lines of two adjacent row decoders, and each of the adjacent row decoders is a row decoder shared by the memory array tile and the memory array tile sharing the sub-wordline driver.

9. The memory according to claim 6, wherein for the memory array tile located at the edge in each section, in the three sub-wordline drivers disposed in the projection region of the memory array tile on the logic circuit chip, the sub-wordline driver shared by the adjacent memory array tile is located in the projection region, and is adjacent to one side of a projection region corresponding to the adjacent memory array tile, and the other two sub-wordline drivers are located on the other side of the projection region.

10. The memory according to claim 9, wherein for the memory array tile located at the edge in each section, the sub-wordline driver shared by the adjacent memory array tile is connected to main decoding signal lines of two row decoders shared by the memory array tile and the adjacent memory array tile, and the other two sub-wordline drivers are connected to main decoding signal lines of the other two row decoders corresponding to the memory array tile.

11. The memory according to claim 5, wherein each sub-wordline driver comprises two sub-wordline driver units, and quantities of drive ports of the two sub-wordline driver units are the same.

12. The memory according to claim 11, wherein each of the sub-decoding signal lines is parallel to the first direction, and each of the main decoding signal lines is perpendicular to the first direction.
